(19) Europäisches Patentamt

European Patent Office

Office européen des brevets

(11) **EP 1 204 948 B1**

(12) **FASCICULE DE BREVET EUROPEEN**

(45) Date de publication et mention
de la délivrance du brevet:
**25.02.2004 Bulletin 2004/09**

(21) Numéro de dépôt: **00953248.2**

(22) Date de dépôt: **17.07.2000**

(51) Int Cl.$^7$: **G06K 19/073**

(86) Numéro de dépôt international:
**PCT/FR2000/002058**

(87) Numéro de publication internationale:
**WO 2001/008088 (01.02.2001 Gazette 2001/05)**

(54) **MICRO-CONTROLEUR SECURISE CONTRE LES ATTAQUES EN COURANT**

GEGEN ANGRIFFE ÜBER DEN STROM GESCHÜTZTER MIKROKONTROLLER

SECURE MICROCONTROLLER AGAINST ATTACKS BASED ON CURRENT CONSUMPTION VALUES

(84) Etats contractants désignés:
**AT BE CH CY DE DK ES FI FR GB GR IE IT LI LU MC NL PT SE**

(30) Priorité: **22.07.1999 FR 9909555**

(43) Date de publication de la demande:
**15.05.2002 Bulletin 2002/20**

(73) Titulaire: **SCHLUMBERGER Systèmes**
**92120 Montrouge (FR)**

(72) Inventeur: **LEYDIER, Robert**
**F-91400 Orsay (FR)**

(74) Mandataire: **den Braber, Gerard Paul**
**50, avenue Jean Jaurès,**
**B.P. 620-12**
**92542 Montrouge Cedex (FR)**

(56) Documents cités:
**EP-A- 0 108 011**        **US-A- 4 827 451**
**US-A- 4 932 053**

## Description

L'invention concerne des micro-contrôleurs destinés à être incorporés dans des objets portatifs et, en particulier, dans de tels objets au format carte plus communément appelés cartes à puce.

Les cartes à puce sont en général utilisées dans des applications dans lesquelles la sécurité du stockage et du traitement de données confidentielles sont essentielles. Elles sont notamment destinées à des applications du domaine de la santé, à des applications de la télévision à péage, ou encore, à des applications bancaires par exemple dites de porte-monnaie électronique.

Les micro-contrôleurs sont des automates programmés réalisés sous forme de circuit intégré. Ils appliquent une suite d'instructions logiques aux données issues de leurs mémoires internes ou provenant du monde extérieur, par l'intermédiaire d'un plot d'entrée/sortie.

Habituellement, les micro-contrôleurs de cartes à puce sont conçus en technologie CMOS. Cette technologie permet d'intégrer, dans un même circuit, des sous-ensembles utiles au fonctionnement du micro-contrôleur, c'est-à-dire notamment une unité centrale de traitement CPU, des mémoires non volatiles non réinscriptibles et en lecture seule de type ROM (Read Only Memory), des mémoires non volatiles réinscriptibles de type Flash. EEPROM (Electrically Erasable Programmable Read Only Memory) ou FRAM (Ferromagnetic Random Access Memory) et des mémoires volatiles RAM (Random Access Memory).

Des fraudeurs ont développés des attaques dites en courant en vue d'obtenir des données confidentielles gérées par le micro-contrôleur et par exemple des clés destinées à la mise en oeuvre d'algorithmes de cryptage implementés dans les micro-contrôleurs tels que les algorithmes connus sous les noms de DES (Data Encryption Standard) ou de RSA (Rivest Shamir Adelman).

Ces attaques sont basées sur le principe suivant lequel l'énergie $Ec_{\mu C}$ consommée par un micro-contrôleur exécutant, dans un intervalle de temps T, une instruction INS appliquée à des opérandes OPE, est toujours la même et constitue une signature. Autrement dit :

$$Ec_{\mu C} \ (T \ ; \ INS \ ; \ OPE) = constante.$$

On notera que, dans la relation ci-dessus, ainsi que dans les relations qui suivront dans la présente description, le signe "=" signifie "sensiblement égal".

Pour la mise en oeuvre des attaques en courant, les fraudeurs connectent notamment une résistance R de faible valeur, notamment d' 1 Ω, en série entre une source d'alimentation en tension $V_{\mu C}$ du micro-contrôleur et son plot d'alimentation VCC. Ils visualisent alors les variations de la tension R Icc(t) en fonction du temps obtenues en réponse à l'exécution de plusieurs centaines voire plusieurs milliers d'instructions appliquées à des opérandes identiques, semblables ou différentes au moyen d'un ordinateur couplé, par exemple, à un oscilloscope numérique qui amplifient ces variations, les échantillonnent et numérisent les résultats obtenus en vue d'une analyse en temps différé.

De telles attaques, qui ont la particularité d'être non destructives, sont redoutables.

C'est la raison pour laquelle les fabricants de micro-contrôleurs et les fabricants de cartes ont développé des procédés destinés à sécuriser les micro-contrôleurs contre ces attaques.

La plupart de ces procédés proposent d'utiliser des programmes qui font intervenir un déclenchement d'opérations à des moments pseudo-aléatoires ou font intervenir des opérations qui génèrent un bruit riche en informations aléatoires ou erronées au cours de l'exécution des instructions par le micro-contrôleur.

Ces procédés montrent cependant de multiples inconvénients. Le temps d'exécution des programmes est long. L'espace mémoire qu'ils occupent est important. Enfin, les données confidentielles ne sont finalement pas protégées contre une analyse approfondie réalisée par les fraudeurs puisque la signature électrique, qui résulte de l'exécution des instructions, est toujours présente.

Un autre procédé, décrit dans la demande de brevet français enregistrée sous le numéro 98 01305, et non rendue publique à la date de priorité de la présente demande, propose de filtrer le courant par une cellule de filtrage passe-bas. Ce procédé permet uniquement d'atténuer les signatures électriques et leur analyse précise permet en définitive d'accéder à certaines données confidentielles.

Le brevet US 4 932 053 concerne quant à lui, la sécurité d'informations confidentielles contenues dans un circuit intégré. Dans un certain nombre d'applications concernant des circuits intégrés et plus particulièrement dans des applications du type carte à puce, il est nécessaire d'interdire l'accès de certaines données confidentielles contenues dans la mémoire du circuit à des personnes non autorisées. Afin d'empêcher le fraudeur de procéder à un examen de la consommation en courant aux extrémités du circuit intégré lors d'une opération de lecture ou d'écriture dans la mémoire, un circuit de protection est utilisé. Ce circuit de protection permet d'activer la simulation, selon une séquence pseudo-aléatoire générée par un générateur, de valeurs de consommation en courant identiques à celles des cellules mémoires réelles.

Notons enfin que le brevet US 4 827451 concerne le domaine des mémoires construites sous forme d'une matrice de cellules mémoires. Lesdites cellules, étant accessibles par les lignes et les colonnes , sont connectées à des circuits de lecture et d'écriture qui sont utilisés pour les programmer selon deux états - "1" ou "0" selon les données d'entrées - et lire l'état ainsi programmé. Les cellules mémoires sont du type nécessitant un courant de programmation afin d'être programmées à "1" et ne nécessitant aucun courant lors de la programmation à "0". Ledit circuit de sécurité consiste en un circuit de simulation s'activant lors d'une programmation à "0" pour délivrer un courant identique à celui délivré par une cellule mémoire lors d'une programmation à "1".

Compte tenu de ce qui précède, un problème technique que se propose de résoudre l'invention est de sécuriser un objet portatif du type carte à puce.

La présente invention est telle que définie dans les reventications dont les préambules sont constitués par les caractéristiques décrites dans US 4 932 053 et US 4 827 451.

Etant donné que la consommation en énergie de ladite partie efficace de traitement de données peut être estimée comme étant directement proportionnelle au carré de sa tension d'alimentation, une variation de cette tension bouleverse les signatures électriques et rend leur analyse difficile voire impossible.

De manière avantageuse, les moyens pour faire varier la tension d'alimentation de la partie efficace de traitement de données comprennent : - une résistance variable en fonction du temps connectée en série avec le plot d'alimentation du micro-contrôleur, cette résistance variable étant par exemple un commutateur ouvert pendant des intervalles de temps $T_{off}$ et fermé pendant des intervalles de temps $T_{on}$, le rapport cyclique $T_{off}/(T_{on} + T_{off})$ variant en fonction du temps, la période $T_{on} + T_{off}$ variant en fonction du temps.

Par ailleurs, les moyens pour faire varier la tension d'alimentation de la partie efficace de traitement de données comprennent avantageusement un générateur d'impulsions, ce générateur d'impulsions comprenant un circuit de synchronisation de franchissement de seuil de tension aux bornes de la partie efficace de traitement de données.

Enfin, les moyens pour faire varier la tension d'alimentation de la partie efficace de traitement de données comprennent en outre avantageusement un condensateur, ce condensateur étant par exemple une capacité dont la capacité est supérieure à 0,1 nanofarad.

Dans certains modes de réalisation avantageux de l'invention le micro-contrôleur comporte une couche principale de silicium dont la face active, qui intègre un circuit et porte les plots de contact, est scellée à une couche complémentaire de protection au moyen d'une couche de scellement, les moyens pour faire varier la tension d'alimentation de la partie efficace de traitement des données étant situés dans la couche complémentaire de protection.

L'invention sera mieux comprise à la lecture de l'exposé non limitatif qui suit, rédigé au regard des dessins annexés, dans lesquels :

- la figure 1 montre, en perspective, une carte à puce selon l'invention ;

- la figure 2 montre, en coupe transversale, une carte à puce selon l'invention ;

- la figure 3 montre, en vue de face, les plages de contact d'une carte à puce selon l'invention ;

- la figure 4 montre, en perspective, un micro-contrôleur selon l'invention ;

- la figure 5 schématise les différentes parties constitutives d'un micro-contrôleur selon l'invention ;

- la figure 6A représente la couche active du micro-contrôleur selon l'invention montré à la figure 4 ;

- la figure 6B représente la couche complémentaire du micro-contrôleur selon l'invention montré à la figure 4 ;

- la figure 7 schématise un inverseur CMOS d'une partie efficace de traitement des données d'un micro-contrôleur selon l'invention ;

- la figure 8 montre les variations du signal $V_e$ de commande, de l'intensité $i_{cc}$ d'alimentation et du signal $V_s$ de sortie de l'inverseur CMOS de la figure 7 en fonction du temps ;

- la figure 9 est un schéma électrique d'un micro-contrôleur selon l'invention ;

- les figures 10A à 10D montrent, respectivement, les variations du signal S, de l'intensité du courant $I_{CAP}$, de la tension $V_{\mu CE}$ et de l'intensité Icc du courant d'alimentation d'un micro-contrôleur selon l'invention en fonction du temps ;

- la figure 11 est un enregistrement comparatif des variations de l'intensité Icc du courant en fonction du temps dans le cas d'un micro-contrôleur selon l'état de la technique (signature A) puis dans le cas d'un micro-contrôleur sécurisé selon l'invention (signature B) ;

- la figure 12 est un schéma électrique d'un mode de réalisation particulier d'un micro-contrôleur selon l'invention ; et

- la figure 13 montre les variations des signaux $S_1$, $S_2$ et $S_3$ en fonction du temps, dans le cas d'un micro-contrôleur correspondant au mode de réalisation de la figure 12.

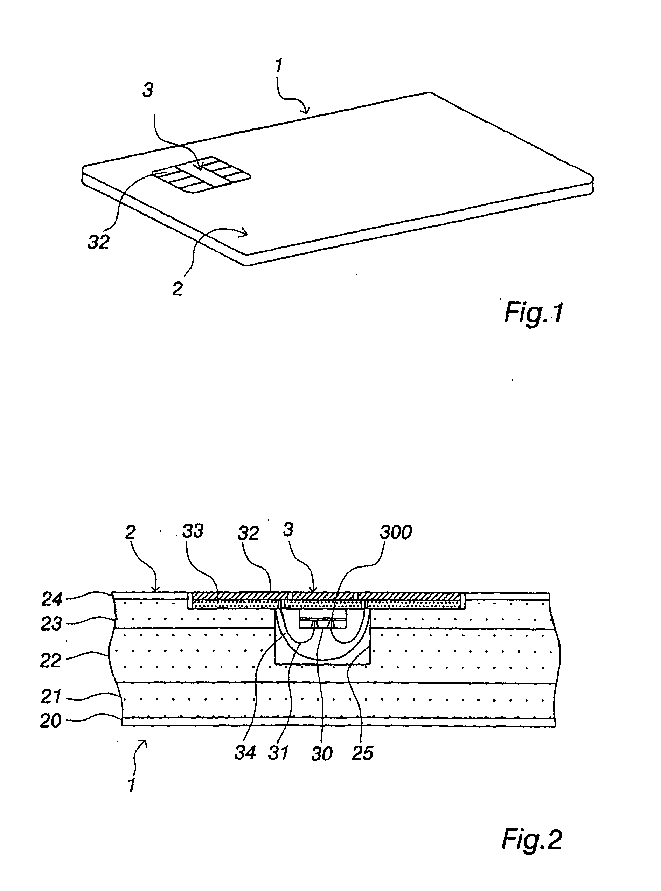

Dans le mode de réalisation montré aux figures 1, 2 et 3, un objet portatif selon l'invention se présente sous la forme d'une carte 1 sensiblement parallélépipèdique rectangle et de faible épaisseur dont un corps 2 intègre un module 3 électronique.

Le corps 2 de carte est par exemple constitué de cinq feuilles 20, 21, 22, 23 et 24 plastiques laminées et comporte une cavité 25 pour l'incorporation du module 3.

Le module 3 comprend un micro-contrôleur 30 dont des plots 300 de contact sont connectés électriquement, au moyen de fils 31 conducteurs, à des plages 32 de contact affleurantes à la surface du corps 2 de carte. Ces plages 32 reposent sur une épaisseur 33 d'un diélectrique du type verre époxy. L'ensemble micro-contrôleur 30 et fils 31 conducteurs est enrobé dans une résine 34 protectrice.

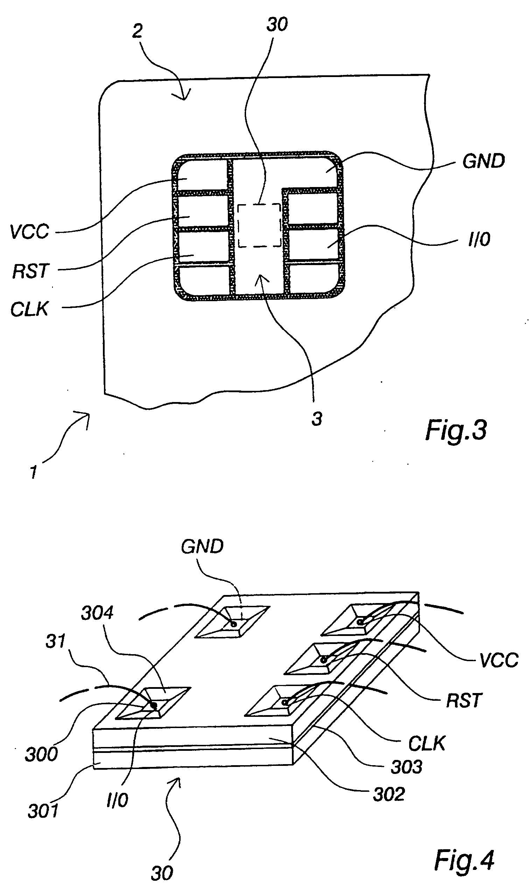

Dans le mode de réalisation de la figure 4, le micro-contrôleur 30 se présente sous la forme d'un parallélépipède rectangle dont l'épaisseur est de l'ordre de 180 μm et dont la surface est de l'ordre de 10 mm$^2$.

Ce micro-contrôleur 30 comporte une couche principale 301 de silicium dont la face active, qui intègre un circuit et porte les plots 300 de contact, est scellée à une couche complémentaire 302 de protection de silicium au moyen d'une couche de scellement 303. Cette couche complémentaire 302 est munie d'ouvertures 304 situées à l'aplomb des plots 300 en vue de permettre leur connexion aux plages 32.

En pratique, les plots 300 sont au nombre de cinq. Il s'agit des plots VCC, RST, CLK, I/O et GND respectivement connectés aux plages de contact VCC, RST, CLK, I/O et GND du module 3. Le plot d'alimentation VCC est destiné à alimenter le micro-contrôleur. Le plot de remise à zéro RST est destiné à la transmission d'un signal de remise à zéro au micro-contrôleur, le plot d'horloge CLK est destiné à la transmission d'un signal d'horloge au micro-contrôleur, le plot d'entrée/sortie I/O est destiné à permettre les échanges de données logiques entre le micro-contrôleur et le monde extérieur et le plot de mise à la masse GND permet la mise à la masse du micro-contrôleur.

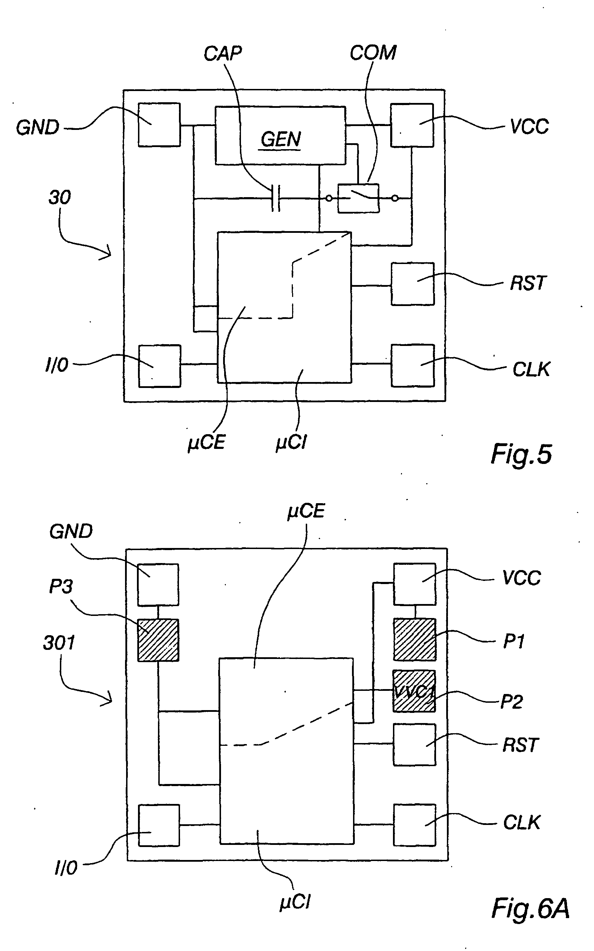

Le circuit intégré du micro-contrôleur 30 selon l'invention comporte différentes parties actives. Il s'agit notamment d'une partie micro-contrôleur interface μCI et d'une partie efficace de traitement des données μCE montrées à la figure 5.

La partie micro-contrôleur interface ou micro-contrôleur interface μCI comporte avantageusement uniquement des moyens qui consomment une énergie qui n'est pas susceptible de révéler des informations quant aux données confidentielles traitées par le micro-contrôleur. En pratique, le micro-contrôleur interface μCI comprend par exemple une pompe de charge ou des circuits d'interface associés aux plots RST, CLK et I/O. En ce qui concerne le plot RST, il s'agit notamment de moyens de détection d'un signal d'initialisation et de moyens associés d'initialisation du micro-contrôleur. En ce qui concerne le plot CLK, il s'agit de moyens de détection de fréquences comprises entre une limite basse et une limite haute. Enfin, en ce qui concerne le plot I/O, il s'agit de moyens destinés à permettre au micro-contrôleur communiquer en passant d'un mode entrée à un mode sortie ou réciproquement.

La partie efficace de traitement des données ou micro-contrôleur efficace μCE est une partie du micro-contrôleur 30 qui comprend des sous-ensembles dont des inverseurs sont destinés au traitement des données confidentielles. Elle constitue de ce fait la partie du micro-contrôleur susceptible de donner aux fraudeurs, des informations sur ces données confidentielles. En pratique, elle comporte l'unité centrale de traitement CPU, éventuellement un cryptoprocesseur associé à cette unité, des circuits de commandes des bus de données et d'adresses ainsi que les mémoires RAM, ROM et EEPROM ou toutes mémoires d'un autre type.

Le micro-contrôleur 30 selon l'invention comprend par ailleurs un générateur d'impulsions GEN, une capacité CAP et un commutateur COM. Le générateur d'impulsions, la capacité et le commutateur sont des moyens pour faire varier la tension d'alimentation du micro-contrôleur efficace.

Le générateur d'impulsions GEN est par exemple formé de deux oscillateurs constitués, pour chacun d'entre eux, d'un inverseur avec hystérésis de type Schmitt sur le circuit d'entrée, d'une capacité connectée entre l'entrée de l'inverseur et la masse et d'une résistance connectée entre la sortie de cet inverseur et son entrée, lesdits deux oscillateurs étant couplés entre eux par une résistance pour constituer une source de signal à fréquence modulée. En outre, le générateur d'impulsions GEN comprend avantageusement un circuit de synchronisation de franchissement d'une tension de seuil $V_{seuil}$ de la tension VμCE aux bornes du micro-contrôleur efficace. Ce circuit peut être formé d'un comparateur de tension dont l'entrée positive est reliée à une tension de référence, la tension $V_{seuil}$, dont l'entrée négative est connectée à la tension aux bornes du micro-contrôleur efficace, et dont la sortie est reliée à l'entrée D d'une bascule synchronisée par le signal de synchronisation issu de la source de signal à fréquence modulée.

La capacité CAP a une capacité supérieure à environ 0,1 nanofarad, notamment comprise entre environ 1 nanofarad et environ 10 nanofarads, par exemple de l'ordre de 6 nanofarads. On notera que les électrodes d'une capacité de 1,5 nanofarad ont une surface de l'ordre de 1 mm$^2$. Aussi, une capacité de 6 nanofarads a une surface de l'ordre de 4mm$^2$.

Le commutateur COM peut être, dans l'invention, remplacé par une résistance variable en fonction du temps connecté en série avec le plot VCC d'alimentation du micro-contrôleur.

Dans l'invention, les plots I / O, RST et CLK sont connectés, par des lignes de connexion électrique, au micro-contrôleur interface μCI. Le plot GND est connecté, par des lignes de connexion électrique, au générateur d'impulsions GEN, à la capacité CAP, au micro-contrôleur efficace μCE et au micro-contrôleur interface μCI. D'autre part, le plot VCC est connecté, par des lignes de connexion électrique, au générateur d'impulsions GEN, au commutateur COM et au micro-contrôleur interface μCI. Par ailleurs, le commutateur COM est connecté, par des lignes de connexion électrique, au générateur d'impulsions GEN et à la capacité CAP. Enfin, une ligne de connexion électrique relie le micro-contrôleur efficace μCE à la ligne de connexion électrique reliant la capacité CAP au commutateur COM et une ligne de connexion électrique relie le générateur GEN à cette dernière ligne de manière à permettre la surveillance de la tension $V_{μCE}$ pour sa comparaison avec la tension $V_{seuil}$.

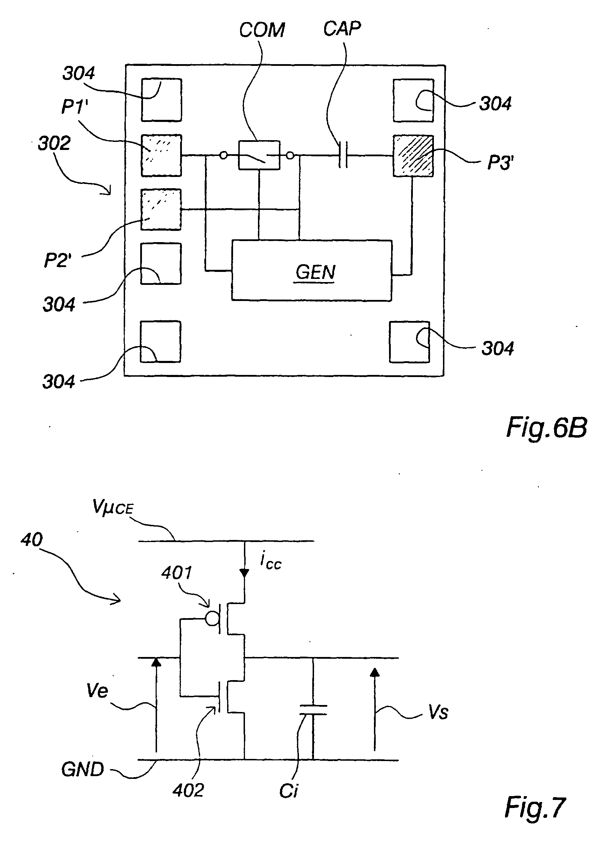

Dans le cas d'un micro-contrôleur du type de la figure 4, les éléments précités sont arrangés à la manière représentée aux figures 6A et 6B dans laquelle la couche complémentaire 302 (figure 6B) comprend le générateur d'impulsions GEN, la capacité CAP et le commutateur COM, et la couche principale 301 (figure 6A), qui porte les plots de contact, comprend les parties micro-contrôleur efficace μCE et micro-contrôleur interface μCI.

En outre, la couche principale 301 comprend trois plots d'interconnexion P1, P2 et P3, un premier plot P1 connecté au plot VCC, un second plot P2 connecté au micro-contrôleur efficace et un troisième plot P3 connecté au plot GND.

De même, la couche complémentaire 302 comprend trois plots d'interconnexion P1', P2' et P3' destinés à venir se placer, dans le micro-contrôleur, au regard et à la verticale des plots P1, P2 et P3, respectivement. Le premier plot P1' est connecté, d'une part, au commutateur COM et, d'autre part, au générateur d'impulsions GEN, le second plot P2' est connecté au point commun entre le commutateur COM et la capacité CAP et le troisième plot P3' est connecté, d'une part, à la capacité CAP et, d'autre part, au générateur d'impulsions GEN.

Dans le micro-contrôleur 30 de la figure 4, les plots P1, P2 et P3 sont respectivement électriquement connectés aux plots P1', P2' et P3' par l'intermédiaire de bossages conducteurs.

Bien entendu, le micro-contrôleur présenté ci-dessus ne constitue qu'un mode de réalisation selon l'invention et il est tout à fait possible de prévoir d'autres modes de réalisation de micro-contrôleurs ne montrant pas une structure en plusieurs couches mais une structure plus classique dans laquelle les différents éléments précités : plots de contact, micro-contrôleurs interface et efficace, capacité, générateur d'impulsions et commutateur, sont intégrés dans une mono-couche de substrat silicium non recouverte d'une couche complémentaire.

L'énergie $Ec_{\mu C}$ consommée par un micro-contrôleur selon l'invention est égale à la somme des énergies $Ec_{\mu CI}$, $Ec_{\mu CE}$ et $Ec_M$ consommées respectivement par le micro-contrôleur interface, le micro-contrôleur efficace et l'ensemble générateur d'impulsions/capacité/com mutateur. On a donc la relation :

$$Ec_{\mu C} = Ec_{\mu CI} + Ec_{\mu CE} + Ec_M$$

L'énergie $Ec_{\mu CI}$ consommée par le micro-contrôleur interface n'est pas révélatrice des instructions exécutées par le micro-contrôleur 30 et par suite pas révélatrice des données confidentielles mises en jeu dans l'exécution desdites instructions.

Les portes élémentaires du micro-contrôleur efficace sont des inverseurs 40 tels que montrés à la figure 7. Ces inverseurs 40 sont formés d'un transistor 401 de type P connecté en série avec un transistor 402 de type N. Le transistor P est porté à la tension $V_{\mu CE}$ et le transistor N est mis à la masse GND. Une capacité $C_i$ est associée à chaque inverseur 40. Cette capacité $C_i$ est la capacité équivalente aux capacités physiques des lignes d'interconnexion de l'inverseur et aux capacités des grilles formant les transistors P et N de l'inverseur éventuellement connecté en aval de l'inverseur de la figure 7.

D'un point de vue fonctionnel, les transistors P et N sont commandés par un signal de commande commun $V_e$ correspondant à la tension en entrée de l'inverseur. Lorsque ce signal transporte un 0 logique ($V_e = $ GND), le transistor P est passant et le transistor N est bloqué de sorte que l'on obtienne un 1 logique en sortie ($V_s = V_{\mu CE}$) et que la capacité $C_i$ se charge. Par contre, lorsque ce signal transporte un 1 logique ($V_e = V_{\mu CE}$), le transistor P est bloqué et le transistor N est passant de sorte que l'on obtienne un 0 logique en sortie ($V_s = $ GND) et que la capacité $C_i$ se décharge.

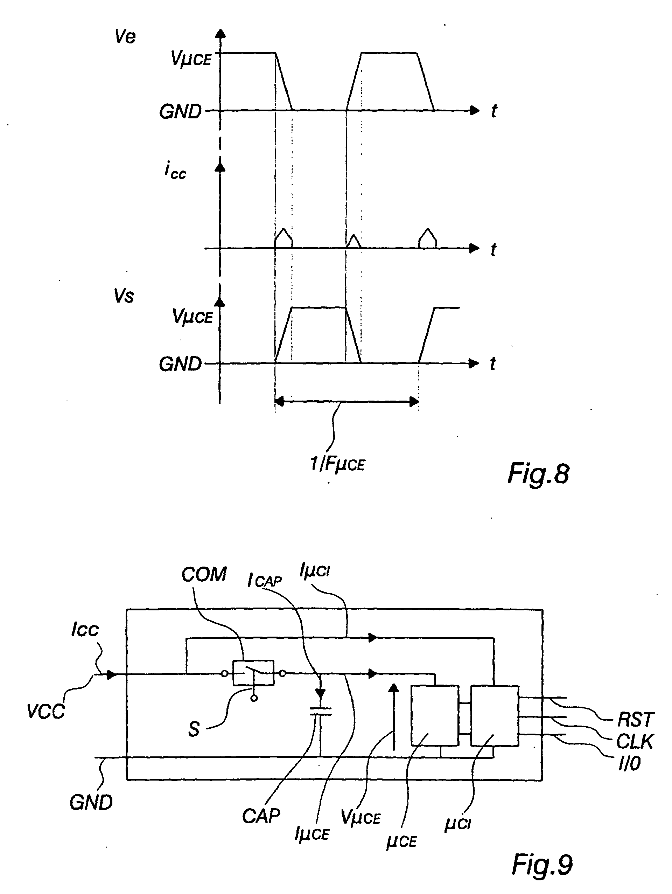

La figure 8 montre les variations du signal de commande $V_e$, de l'intensité du courant d'alimentation $i_{cc}$ et du signal de sortie $V_s$ en fonction du temps t, dans le cas où la fréquence de travail de l'inverseur est égale à $F_{\mu CE}$, qui est en général la fréquence de l'horloge imposée par le terminal via le plot CLK, mais qui peut être une fréquence particulière, dans le cas où le micro-contrôleur est pourvu de moyens de génération d'une horloge interne.

Lorsque la tension $V_e$ est constante, les transistors P et N sont bloqués et l'inverseur 40 est parcouru par un courant de fuite non visible à la figure 8 dont la valeur moyenne est $I_f$ sur une période $1/F_{\mu CE}$. L'énergie dissipée, ou énergie statique $E_s$, est alors égale à :

$$E_s = V_{\mu CE}\, I_f/F_{\mu CE}.$$

Lorsque la tension $V_e$ varie de manière que le signal à l'entrée de l'inverseur passe d'un 1 logique à un 0 logique ou réciproquement, l'intensité du courant $i_{cc}$ varie à la manière indiquée à la figure 8.

L'inverseur consomme une énergie de court circuit $E_{cc}$, qui est égale à :

$$E_{cc} = V_{\mu CE}\, I_{SC}/F_{\mu CE}$$

où $I_{sc}$ est la valeur moyenne de l'intensité du courant de court circuit sur la période $1/F_{\mu CE}$.

De surcroît, lorsque la tension $V_e$ varie de manière que le signal à l'entrée de l'inverseur passe d'un 1 logique à un 0 logique, la capacité $C_i$ se charge jusqu'à atteindre la valeur de tension $V_{\mu CE}$ et l'énergie dynamique $E_d$ alors consommée est égale à la somme de l'énergie emmagasinée dans la capacité $C_i$ sous forme d'énergie électrostatique et de l'énergie dissipée dans la résistance équivalente de limitation du courant de charge, ici le transistor de type P, soit :

$$E_d = 1/2\ C_i\ V^2_{\mu CE} + 1/2\ C_i\ V^2_{\mu CE} = C_i\ V^2_{\mu CE}.$$

Enfin, lorsque la tension $V_e$ varie de manière que le signal à l'entrée de l'inverseur passe d'un 0 logique à un 1 logique, la capacité $C_i$ se décharge au travers du transistor N en dissipant l'énergie préalablement emmagasinée et égale à $1/2\ C_i\ V^2_{\mu CE}$.

Pour un inverseur réalisé en technologie CMOS, $E_{cc}$ est inférieure à 20 % de $E_d$ et $E_s$ est très inférieure à $E_d$. Aussi, l'énergie $E_c$ consommée par l'inverseur i est principalement dynamique et on estime que $E_c$ est sensiblement égale à $E_d$.

Aussi, l'énergie consommée par le micro-contrôleur efficace sur une transition d'horloge est, lorsque ledit micro-contrôleur efficace est alimenté par la tension $V_{\mu CE}$, sensiblement égale à :

$$Ec_{\mu CE} = \sum_{i=1}^{i=N} \alpha_i\ C_i\ V2_{\mu CE}$$

où $\alpha_i = 1$ lorsque l'inverseur i consomme une énergie en faisant notamment l'objet d'une commutation durant cette transition et $\alpha_i = 0$ lorsque l'inverseur i ne consomme pas d'énergie en ne faisant notamment pas l'objet de commutation au cours de cette transition et où N est le nombre d'inverseurs dans le micro-contrôleur efficace.

L'énergie consommée par le micro-contrôleur efficace varie donc avec le carré de sa tension d'alimentation $V_{\mu CE}$.

L'énergie $Ec_M$ consommée par les moyens de l'invention est égale à l'énergie $Ec_{GEN}$ consommée par le générateur d'impulsions GEN additionnée à l'énergie $Ec_{COM}$ consommée par le commutateur COM et à l'énergie $Ec_{CAP}$ consommée par la capacité CAP. Aussi :

$$Ec_M = Ec_{GEN} + Ec_{COM} + Ec_{CAP}$$

L'énergie $Ec_{GEN}$ consommée par le générateur d'impulsions GEN est du même type que l'énergie consommée par le micro-contrôleur interface. En effet, elle ne révèle aucune indication sur les données confidentielles mises en jeu dans l'exécution des instructions.

L'énergie $Ec_{COM}$ consommée par le commutateur COM est en fait l'énergie dissipée par ce commutateur lorsque la capacité CAP se charge. Aussi :

$$Ec_{COM} = Ec_{CAP}\ \text{durant sa charge.}$$

L'énergie $Ec_{CAP}$ consommée par la capacité CAP dépend de l'état ouvert ou fermé du commutateur COM. L'état ouvert ou fermé du commutateur COM est commandé par le générateur d'impulsions GEN. En effet, ce générateur est apte à envoyer un signal S de commande d'ouverture ou de fermeture du commutateur COM. Selon le signal S reçu, ce commutateur est fermé ou ouvert. Il est fermé pendant des intervalles de temps $T_{on}$. Il est ouvert pendant des intervalles de temps $T_{off}$.

Dans l'intervalle de temps $T_{off}$ la capacité se décharge et l'énergie qu'elle consomme est égale à $Ec_{CAP}(T_{off})$ telle que :

$$Ec_{CAP}(T_{off}) = -\ 1/2\ C\ \Delta V^2$$

où $\Delta V$ représente la variation de tension aux bornes de la capacité dans $T_{off}$.

Dans l'intervalle de temps $T_{on}$, la capacité, alimentée par le courant d'intensité Icc, se charge, et son énergie consommé $Ec_{CAP}(T_{on})$ est égale à :

$$Ec_{CAP}(T_{on}) = 1/2\ C\ \Delta V^2$$

où $\Delta V$ représente la variation de tension aux bornes de la capacité dans $T_{on}$.

Un fraudeur n'a accès qu'à l'intensité du courant d'alimentation du micro-contrôleur dans son ensemble et par suite qu'à l'énergie consommée par le micro-contrôleur dans son ensemble.

Dans l'intervalle de temps $T_{off}$, l'énergie consommée par le micro-contrôleur est égale à l'énergie consommée par le micro-contrôleur interface. En effet, le micro-contrôleur efficace est alimenté par la capacité CAP qui se décharge. Aussi, dans $T_{off}$ :

$$Ec_{\mu C} = Ec_{\mu CI}.$$

Or, ainsi que cela a été vu plus haut, $Ec_{\mu CI}$ ne révèle aucune information sur le basculement des inverseurs du micro-contrôleur efficace et par suite aucune information sur les données confidentielles traitées. Aussi, grâce à l'invention, le fraudeur ne pourra pas avoir accès auxdites données pendant les intervalles de temps $T_{off}$.

Par contre, dans l'intervalle de temps $T_{on}$, l'énergie consommée par le micro-contrôleur est égale à l'énergie consommée par le micro-contrôleur interface, additionnée à l'énergie consommée par les moyens selon l'invention et additionnée à l'énergie consommée par le micro-contrôleur efficace. Aussi :

$$Ec_{C\mu} = Ec_{\mu CI} + Ec_{\mu CE} + Ec_M.$$

Soit une instruction INS appliquée sur les mêmes opérandes OPE et exécutée par le micro-contrôleur selon l'invention. En pratique, cette instruction INS est exécutée sur quelques transitions d'horloge. A chaque transition d'horloge, une partie de l'instruction INS est exécutée et certains des N inverseurs du micro-contrôleur efficace font l'objet d'un changement d'état à cet effet.

L'énergie consommée par le micro-contrôleur efficace au cours d'une telle transition est directement proportionnelle au carré de la tension $V_{\mu CE}$ aux bornes dudit micro-contrôleur.

Comme la capacité CAP est connectée en parallèle avec le micro-contrôleur efficace, la tension $V_{\mu CE}$ aux bornes du micro-contrôleur efficace est la même que la tension $V_{CAP}$ aux bornes de la capacité CAP. Aussi, la tension aux bornes du micro-contrôleur efficace varie constamment.

C'est la raison pour laquelle l'énergie consommée pour l'exécution d'une partie d'instruction INS et, a fortiori, pour une instruction INS, n'est pas toujours la même.

En fait, dans le cas d'instructions identiques appliquées aux mêmes opérandes, la différence entre les énergies consommées par le micro-contrôleur efficace est d'autant plus grande qu'elles sont fonctions du carré de la tension d'alimentation $V_{\mu CE}$ de ce micro-contrôleur.

Il résulte de ce qui précède que le principe cité dans le préambule de la présente description selon lequel $Ec_{\mu C}$ (T ; INS ; OPE) = constante n'est plus vrai dans l'invention et le fraudeur ne pourra donc pas accéder aux informations confidentielles.

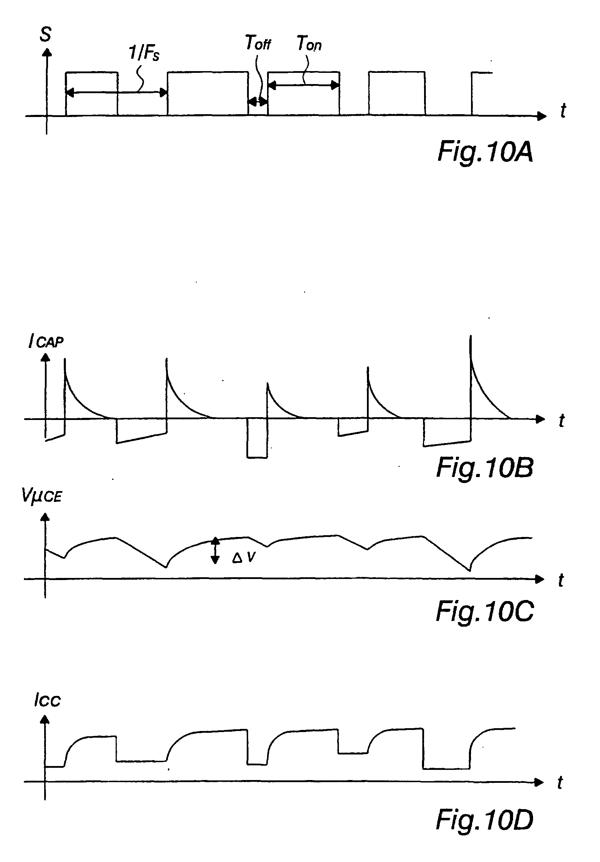

Les figures 10A à 10D visualisent respectivement le signal S, l'intensité $I_{CAP}$ du courant d'alimentation de la capacité CAP, la tension $V_{\mu CE}$ d'alimentation du micro-contrôleur efficace et l'intensité du courant Icc d'alimentation du micro-contrôleur en fonction du temps t.

Ainsi que cela est montré à la figure 10A, les intervalles de temps $T_{off}$ et $T_{on}$ varient d'une période $T_s$ = $T_{off}$ + $T_{on}$ à une autre. Le rapport cyclique $T_{off}/(T_{on} + T_{off})$ varie donc au cours du temps et, avantageusement, de manière aléatoire et par suite imprévisible pour le fraudeur. En outre, étant donné que la fermeture du commutateur COM n'est pas réalisée à l'instant précis où la tension aux bornes de la capacité atteint la valeur seuil $V_{seuil}$ mais au premier coup d'horloge suivant cet instant, et que l'intervalle de temps entre ledit instant et ce premier coup d'horloge est variable, la valeur de $T_s$ = $1/F_s$ varie de manière aléatoire. Aux variations de $T_s$ décrites ci-avant, s'ajoutent des variations de $T_s$ dues à la manière dont est réalisée le générateur d'impulsions, comprenant deux oscillateurs couplés avec inverseur de type Schmitt.

D'autre part, ainsi que cela est montré à la figure 10B, l'intensité du courant $I_{CAP}$ d'alimentation de la capacité CAP est positive durant les intervalles de temps $T_{on}$ au cours desquels la capacité se charge. Par contre, $I_{CAP}$ décroît dans ces intervalles jusqu'à ce que $I_{CAP}(t) = 0$. De ce fait, la capacité est en charge maximale au moment où le commutateur passe à l'état ouvert. Par ailleurs, l'intensité du courant $I_{CAP}$ est négative dans les intervalles de temps $T_{off}$ au cours desquels la capacité se décharge pour alimenter le micro-contrôleur efficace.

Ainsi que cela est montré à la figure 10C, la tension d'alimentation $V_{\mu CE}$ du micro-contrôleur efficace croît dans les intervalles de temps $T_{on}$ et décroît dans les intervalles de temps $T_{off}$. $\Delta V$ représente la profondeur de la modulation de la tension aux bornes de la capacité.

Enfin, ainsi que cela est montré à la figure 10D, l'intensité Icc du courant d'alimentation du micro-contrôleur est égale à $I_{\mu CI}$ dans $T_{off}$ puis augmente dans $T_{on}$, où elle est égale à $I_{\mu CI} + I_{CAP} + I_{\mu CE}$.

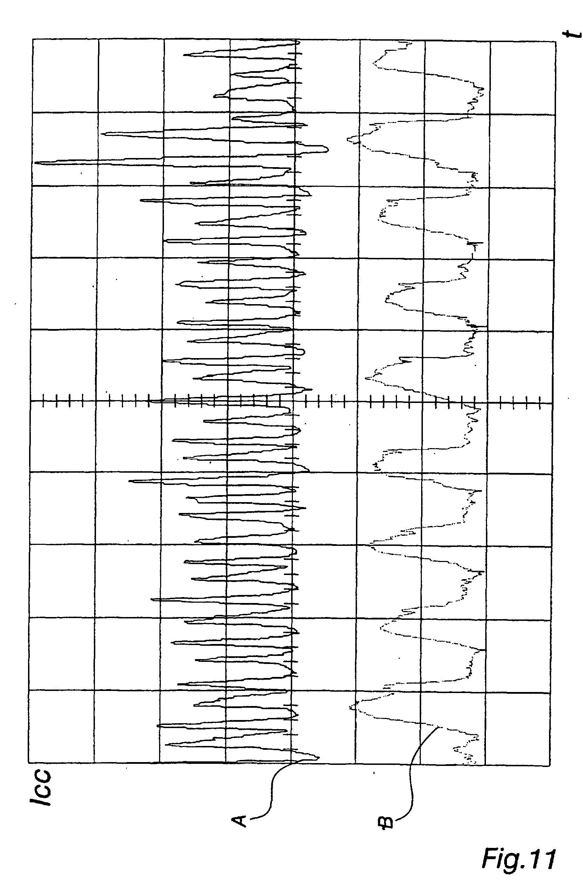

La figure 11 montre les variations de l'intensité du courant Icc en fonction du temps t, d'une part, dans le cas d'un micro-contrôleur selon l'état de la technique (signature A) et, d'autre part, dans le cas d'un même micro-contrôleur selon l'invention (signature B) pour l'exécution d'instructions identiques appliquées sur des mêmes opérandes. Bien que l'exécution de ces instructions se déroule de la même manière dans le temps, les courbes sont totalement différentes. Les pics d'intensité visibles sur la première courbe ne le sont plus sur la seconde courbe. Les intervalles de temps $T_{off}$ et $T_{on}$ apparaissent clairement sur la seconde courbe. Il est ainsi particulièrement difficile de déterminer quoi que ce soit concernant les données confidentielles à partir de la seconde courbe.

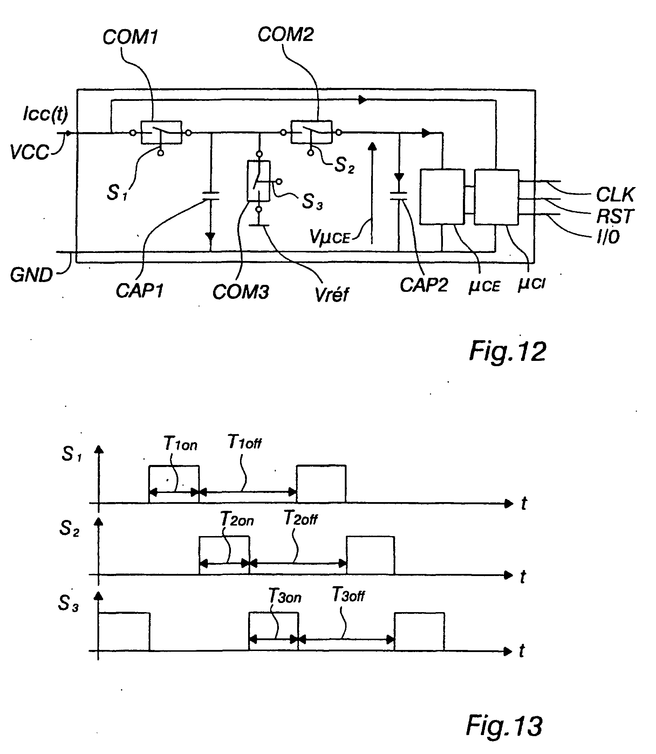

Bien entendu, la description du mode de réalisation de l'invention exposé ci-dessus n'est nullement limitative de l'invention qui doit se comprendre de manière large. D'autres modes de réalisation plus complexes sont susceptibles de donner des résultats particulièrement intéressants. Il s'agit par exemple du mode de réalisation présenté à la figure 12 montrant un micro-contrôleur muni de deux capacités CAP1 et CAP2, trois commutateurs COM1, COM2 et COM3 et trois signaux S1, S2 et S3 de commande de l'ouverture et de la fermeture des trois commutateurs COM1, COM2 et COM3, respectivement. Dans ce mode de réalisation, la capacité CAP1 est déchargée à une tension de référence, par exemple GND, au travers du commutateur COM3 alors que les commutateurs COM1 et COM2 sont ouverts, avant d'être rechargée au travers du commutateur COM1 alors que les commutateurs COM2 et COM3 sont ouverts. La capacité CAP1, une fois chargée au travers du commutateur COM1, se décharge dans la capacité CAP2 en parallèle avec le micro-contrôleur efficace µCE au travers du commutateur COM2 alors que les commutateurs COM1 et COM2 sont ouverts. A la figure 13, on a montré le déroulement des signaux $S_1$, $S_2$ et $S_3$ dans le temps. Le mode de réalisation permet de consommer une énergie constante indépendante de l'activité du µCE. Il n'est plus possible d'obtenir des informations confidentielles en analysant le courant Icc. Ce mode de réalisation augmente la consommation énergétique du micro-contrôleur efficace.

## Revendications

1. Micro-contrôleur (30) destiné à être incorporé dans un objet portatif (1) du type carte à puce, le micro-contrôleur comprenant :

   - un plot de contact (VCC) pour l'alimentation en courant dudit micro-contrôleur (30);
   - un plot (I/O) d'entrée et/ou de sortie de données ;
   - une partie efficace (μCE) pour effectuer un traitement de données, les données comprenant des informations confidentielles ;

   **caractérisé en ce qu'**un circuit d'interface (COM, GEN, CAP) à travers lequel la partie efficace (μCE) reçoit une tension d'alimentation (VμCE), ledit circuit interface (COM, GEN, CAP) étant agencé pour faire varier la tension d'alimentation de la partie efficace de traitement de données (μCE) en modulant le couplage électrique entre le plot de contact (VCC) et la partie efficace (μCE) afin de sécuriser lesdites données confidentielles contre les attaques en courant.

2. Objet portatif (1) du type carte à puce, comprenant un micro-contrôleur (30) selon la revendication 1.

3. Objet portatif du type carte à puce selon la revendication 2 **caractérisé en ce que** le circuit d'interface comprend :

   - un commutateur (COM) entre ledit plot de contact (VCC) et une borne d'alimentation de la partie efficace de traitement de données (μCE);
   - une capacité (CAP) connectée entre ladite borne d'alimentation ; de la partie efficace du micro-contrôleur (μCE) et une autre borne d'alimentation de la partie efficace (μCE).

4. Objet portatif du type carte à puce selon la revendication 3 **caractérisé en ce que** le circuit d'interface comprend un générateur d'impulsion (GEN) pour contrôler le commutateur (COM) de façon désynchronisée par rapport audit traitement de données.

5. Objet portatif du type carte à puce selon la revendication 4 ou la revendication 3 **caractérisé en ce que** la capacité a une capacité supérieure à 1 nanofarad.

6. Objet portatif du type carte à puce selon la revendication 2 **caractérisé en ce que** le micro-contrôleur comporte une couche principale (301) de silicium dont la face active, qui intègre un circuit et porte les plots (300) de contact, est scellée à une couche complémentaire (302) de protection au moyen d'une couche de scellement (303).

7. Objet portatif du type carte à puce selon la revendication 6 **caractérisé en ce que** ledit circuit d'interface (COM, GEN, CAP) est situé dans la couche complémentaire de protection (302).

## Claims

1. Microcontroller (30) intended to be incorporated in a portable object (1) of type smartcard, the microcontroller comprising:

   - a contact stud (VCC) to supply said microcontroller (30) with current;
   - a data input and/or output contact stud (I/O);
   - an efficient data processing part (μCE) to process data, the data comprising confidential data;

   **characterized in that** an interface circuit (GEN, CAP, COM) through which the efficient data processing part (μCE) receives a supply voltage (VμCE), said being interface circuit (COM,GEN, CAP) being arranged to vary the supply voltage of the efficient data processing part (μCE) by modulating the electrical couple between the contact stud (VCC) and the efficient data processing part (μCE) to secure said confidential data against current attacks.

2. Portable object (1) of type smartcard, comprising a micro-controller (30) according to claim 1.

3. Portable object of type smartcard according to claim 2 **characterized in that** the interface circuit comprises:

   - a switch (COM) between said contact stud (Vcc) and a supplying stud of the efficient data processing part (μCE);
   - a capacitor (CAP) connected between said supplying stud of the efficient part of microcontroller (μCE) and an other supplying stud of the efficient part (μCE).

4. Portable object of smartcard type according to claim 3 **characterized in that** the interface circuit comprises a pulse generator (GEN) to control the switch (COM) in a non synchronous manner regarding said data processing.

5. Portable object of smartcard type according to claim 4 or 3 **characterized in that** the capacitor has a capacitance of greater than 1 nanofarad.

6. Portable object of smartcard type **characterized in that** the microcontroller comprises a main layer (301) of silicon whose active face, which includes a circuit and supports the contact studs (300), is sealed to an additional protective layer (302) using a sealing layer (303).

7. Portable object of smartcard type according to claim 6 **characterized in that** the interface circuit (COM, CAP, GEN) is located in the additional protective layer (302):

**Patentansprüche**

1. Mikrocontroller (30) zum Einbau in ein tragbares Objekt (1) vom Typ Chipkarte, wobei der Mikrocontroller folgende Elemente umfasst:

   - einen Kontakt (VCC) zur Stromversorgung des besagten Mikrocontrollers (30);
   - einen Kontakt (I/O) für den Ein- und/oder Ausgang von Daten;
   - einen Wirkbereich ($\mu$CE) zur Verarbeitung von Daten, in denen vertrauliche Daten enthalten sind;

   **dadurch gekennzeichnet, dass** eine Schnittstellenschaltung (COM, GEN, CAP), über die der Wirkbereich ($\mu$CE) eine Versorgungsspannung (V$\mu$CE) erhält, angeordnet ist, um die Versorgungsspannung des Wirkbereichs zur Datenverarbeitung ($\mu$CE) durch Modulation der Stromkopplung zwischen dem Kontakt (VCC) und dem Wirkbereich ($\mu$CE) variieren zu lassen, um besagte vertrauliche Daten gegen Stromangriffe abzusichern.

2. Tragbares Objekt (1) vom Typ Chipkarte mit einem Mikrocontroller (30) nach Patentanspruch 1.

3. Tragbares Objekt vom Typ Chipkarte nach Patentanspruch 2, **dadurch gekennzeichnet, dass** die Schnittstellenschaltung folgende Elemente umfasst:

   - einen Umschalter (COM) zwischen besagtem Kontakt (VCC) und einem Versorgungsanschluss des Wirkbereichs zur Datenverarbeitung ($\mu$CE);
   - eine Kapazität (CAP), die zwischen besagtem Versorgungsanschluss des Mikrocontrollerwirkbereichs ($\mu$CE) und einem anderen Versorgungsanschluss des Wirkbereichs ($\mu$CE) angeschlossen ist.

4. Tragbares Objekt vom Typ Chipkarte nach Patentanspruch 3, **dadurch gekennzeichnet, dass** die Schnittstellenschaltung zur in Bezug auf besagte Datenverarbeitung entsynchronisierten Kontrolle des Umschalters (COM) einen Impulsgenerator (GEN) umfasst.

5. Tragbares Objekt vom Typ Chipkarte nach Patentanspruch 3 oder 4, **dadurch gekennzeichnet, dass** die Kapazität eine Kapazität von über 1 Nanofarad aufweist.

6. Tragbares Objekt vom Typ Chipkarte nach Patentanspruch 2, **dadurch gekennzeichnet, dass** der Mikrocontroller eine Hauptschicht (301) aus Silizium umfasst, deren aktive Seite, welche eine Schaltung und die Kontakte (300) enthält, mittels einer Schweißschicht (303) mit einer zusätzlichen Schutzschicht (302) verschweißt ist.

7. Tragbares Objekt vom Typ Chipkarte nach Patentanspruch 6, **dadurch gekennzeichnet, dass** sich besagte Schnittstellenschaltung (COM, GEN, CAP) in der zusätzlichen Schutzschicht (302) befindet.

*3*

*1*

*32*

*2*

**Fig.1**

*2* *33* *32* *3* *300*

*24*

*23*

*22*

*21*

*20*

*1*

*34* *31* *30* *25*

**Fig.2**

2  30

GND

VCC

RST

CLK

I/0

3

*Fig.3*

1

GND

304

31

300

301

I/0

30

VCC

RST

CLK

303

302

*Fig.4*

Fig.5

Fig.6A

COM    CAP

304

P1'

302

P2'

304

304

GEN

304

P3'

304

*Fig.6B*

VμCE

40

401

$i_{cc}$

Ve

Vs

GND

402    Ci

*Fig.7*

Fig.8

Fig.9

Fig.10A

Fig.10B

Fig.10C

Fig.10D

Fig.11

Fig.12

Fig.13